# EUROPEAN PATENT APPLICATION

(11) **EP 4 060 836 A1**
(43) Date of publication of application: **21.09.2022**
(21) Application number: 21162903.5
(22) Date of filing: 16.03.2021
(51) Int. Cl.: H01S 5/187, H01S 5/34, H01S 5/12

(54) **VERTICAL EMISSION CASCADE LASERS**

(71) Applicant: Sensirion AG, 8712 Stäfa (CH)
(72) Inventor: Jouy, Pierre, 8712 Stäfa (CH)
(74) Representative: Keilitz Haines & Partner Patentanwälte PartGmbB

(57) **Abstract**

A vertical emission cascade laser (10) comprising in sequence a lower cladding layer (14), active region layers (15) and an upper cladding layer (16), these collectively forming an in-plane waveguide. The upper cladding layer (16) is structured to define a higher order grating (28) of concentric rings, the higher order grating being of order *m* in respect of the lasing wavelength, A, where *m* is at least 2. The higher order grating (28) has a radial periodicity Λ = m·λ / 2·*n*, where *n* is the effective refractive index for the radial mode. The radial periodicity is perturbed to follow a Bessel distribution. The higher order grating (28) has a dual function. First, it selects a specific radial mode for lasing within the in-plane waveguide. Second, it acts as a diffraction grating to couple out a component of the lasing, radial mode from the active region layers (15) as the laser beam.

## Description

### BACKGROUND OF THE INVENTION

The invention relates to vertical emission cascade lasers.

Cascade laser is a generic term for quantum cascade laser (QCL) and interband cascade laser (ICL), wherein the former is based on cascading intraband transitions between subbands of quantum wells in a Type I superlattice structure, whereas the latter is based on cascading interband transitions between subbands of quantum wells in a Type II (or sometimes Type I) superlattice structure. Cascade lasers emit in the infrared, with QCLs having been demonstrated with emission wavelengths from 2.6 µm up to 250 µm. QCLs are in much more widespread use than ICLs, so the following summary of the prior art is exclusively concerned with QCLs.

Most QCLs, including perhaps all commercially available devices, are based on an edge-emitting structure similar to the structure of a standard edge-emitting laser diode. In an edge-emitting laser diode the laser emission is lateral in relation to the semiconductor heterostructure stack. An opposed pair of cleaved facets form a Fabry-Perot cavity familiar from general laser resonator design. One cleaved facet acts as a back reflector and the other as an output coupler. Without other measures, an edge-emitting laser diode will have multi-mode emission. One way to provide single-mode emission is to fabricate an in-plane grating along the waveguiding layer, such lasers being called distributed feedback (DFB) lasers. Another way to provide single-mode emission is to provide an in-plane grating at one end of the waveguiding layer to provide a back reflector, such a mirror being called a distributed Bragg reflector (DBR) and the laser a DBR laser. External cavity designs are also well known in which one or both the facet surfaces are made non-reflective, so that the semiconductor chip then acts solely as a gain medium, i.e. like a rod in an old-style laser resonator design such as ruby or Ti:sapphire. QCLs are known that follow these edge-emitting diode laser design features in a one-to-one analogy, i.e. cleaved facet reflector QCLs, DFB QCLs, DBR QCLs, and external cavity QCLs.

Another common type of semiconductor laser diode is the vertical cavity surface emitting laser (VCSEL), where emission takes place in the growth direction of the stack, i.e. perpendicular to the plane of the heterostructure layers, most commonly from the top surface. A VCSEL has a resonator design in which top and bottom mirrors (output coupler and back reflector) for forming a Fabry-Perot cavity are fabricated as DBRs, e.g. with alternating layers of GaAs and GaAIAs. Namely, a superlattice stack of layers is grown to form a Bragg reflector for each mirror, the two Bragg reflectors being arranged either side of the active layers in the layer stack. A standard VCSEL emits through the top of the stack, but some special designs emit through the bottom, i.e. through the substrate, these being referred to as bottom-emitting VCSELs (even though they are not surface emitting as such).

As mentioned above, commercially available QCLs are based on an edge-emitting laser diode structure. It would in principle be desirable, if it were possible to fabricate QCLs in a vertical emission configuration. It could be expected that vertically emitting QCLs might have similar advantages to those enjoyed by VCSELs over edge-emitting laser diodes, such as lower beam divergence, better far-field beam quality, the ability to fabricate more devices per wafer, the ability to perform *in situ* testing of laser function on the wafer during fabrication, no high-quality cleaving needed, and the possibility of combining multiple adjacent lasers into a monolithic laser array device. However, a conventional VCSEL geometry using DBRs cannot be used for a QCL. This is because polarization selection rules in a QCL mean that intraband transitions involving vertically travelling photons provide no gain. A straightforward implementation of a vertically emitting QCL in one-to-one analogy with a VCSEL design is therefore not possible. The electric field of the light generated in a QCL is always polarized in the growth direction, so only gain in the TM mode is possible.

Several vertical emission QCL designs have been proposed in the research literature [1-4] which avoid this limitation by using an in-plane waveguide mode for lasing combined with a second order grating to couple out a portion of the laser radiation vertically.

Süess *et al* 2016 [1] discloses a vertically emitting QCL based on a linear ridge waveguide. End mirrors are formed by respective first order grating DBR structures fabricated at each end of the ridge waveguide, the periodicity of the first order gratings also providing mode selection. In addition, for vertical outcoupling, a second order grating is fabricated in the manner of a DFB structure on top of the ridge waveguide. The second order grating refracts a portion of the light from the lasing mode out of the waveguide in the vertical direction to provide for vertical outcoupling and so emission from the top surface of the chip.

Szedlak *et al* 2014 [2] discloses a vertically emitting QCL in the form of a ring laser in which a circular ridge waveguide forms a ring. The waveguide mode exploited for gain and laser action is selected by a second order DFB grating fabricated on top of the ring that also serves as an outcoupling element that refracts the light in vertical direction and thus allows for vertical outcoupling from the waveguide and so emission from the top surface of the chip. The grating "lines" are thus radially extending at equal angular offsets with respect to the circle defined by the ring.

Mahler *et* al 2009 [3] discloses a vertically emitting QCL in the form of a microdisk laser based on a cylindrical waveguide. A microdisk laser is a special type of resonator in which the waveguide mode exploited for gain and laser action is a whispering gallery mode, i.e. a mode created by total internal reflections of photons travelling around the perimeter of the disk.

The above-mentioned prior art designs, whether linear ridges [1], circular ridges [2] or microdisks [3], are difficult to fabricate in the sense that the emission wavelength requires a careful match between the grating pitch and the ridge width. However, these two parameters are defined in independent lithographic steps. Therefore any deviation from specification for either parameter during the fabrication will result in the emission wavelength deviating from the design specification.

Liang *et* a/2013 [4] discloses a vertically emitting QCL emitting at about 80 micrometres (3.73 THz). The active region is formed by a GaAs/GaAIAs heterostructure. A concentric circular grating (CCG) is formed by metal rings on the surface of the semiconductor heterostructure. The CCG selects an azimuthal mode for lasing, i.e. a waveguiding mode that propagates angularly around the ring structure. The concentric rings have angular breaks at 120 degree intervals to form a three-spoked bridge structure that allows the grating to be electrically pumped to excite the desired azimuthal mode. A further unstructured metal layer is arranged underneath the active region, so that the relevant waveguide mode in the semiconductor material is confined by metal layers above and below to have substantial overlap with the active (gain) region.

### SUMMARY OF THE INVENTION

According to one aspect of the invention, there is provided a cascade laser comprising a plurality of semiconductor layers extending in respective horizontal planes perpendicular to a vertical direction. The cascade laser is configured to emit a laser beam at a lasing wavelength, λ. The semiconductor layers comprise in sequence:
- a lower cladding layer;
- a plurality of active region layers to provide a gain medium for the cascade laser; and
- an upper cladding layer.
The semiconductor layers collectively form an in-plane waveguide in a horizontal plane. The upper or lower cladding layer is structured to define a higher order grating of concentric rings that forces the in-plane waveguide to support a radial mode having substantial overlap with the gain medium and to couple out a component of the radial mode from the active region layers as the laser beam, the higher order grating being of order m in respect of the lasing wavelength, λ, where *m* is at least 2.

The semiconductor layers will of course be grown epitaxially in sequence on a suitable substrate, the substrate thus supporting the semiconductor layers. However, in some instances it may be beneficial to remove the substrate after growth, for example with a lapping and selective etching process, so the original substrate at the time of growth may not be present in the final device.

Compared with above-mentioned prior art designs, whether linear ridges [1] or circular ridges [2] or microdisks [3], the proposed design is inherently more suited to delivering better yields, since the lasing wavelength is solely defined by the grating geometry, i.e. by a single lithographic step, rather than by matching grating pitch and ridge width, i.e. by two separate lithographic steps. Moreover, for the same reason, better reproducibility of the specified lasing wavelength should be achievable.

By using a radial mode as the optical mode for lasing, a good overlap between the lasing optical mode and the gain medium can be provided in a relatively small wafer area. In particular, the overlap between the optical mode and the gain medium can be made larger than is possible for whispering gallery modes in microdisks. Moreover, a radial mode design can generally provide a smaller area device compared with a ring laser.

In some embodiments, the higher order grating is of order m = 2, i.e. a second order grating. In other embodiments, the higher order grating may be of order m = 3, 4 or more. By 'higher order' in this document we mean *m* ≥ 2.

In some embodiments, there is additionally provided a first order grating of concentric rings that are co-concentric with the concentric rings of the higher order grating. The first order grating is of order m, where m = 1. The first order grating has a radial periodicity of Λ = λ / *2·n.* The first and higher order gratings thus have matched periodicities. If there is both a higher order grating and a first order grating, then both collectively define the lasing, radial mode. If there is no first order grating, i.e. only a higher order grating, then the lasing, radial mode is solely defined by the higher (e.g. second) order grating.

Combining a first order grating with the higher order grating is a useful aid to design, since the first order grating does not contribute to the outcoupling but does contribute to the mode confinement, whereas the higher order grating contributes to both. The joint design of the first order grating and higher order grating can therefore allow any desired amount of coupling out of the cavity to be designed in, e.g. to take account of the amount of gain in the active region.

It is noted that generally for a linear grating, the periodicity, Λ, is given by Λ = *m*·λ / 2·*n*, where *n* is the effective refractive index for the radial mode. However, with a concentric circular grating (CCG), the theoretically ideal periodicity does not exactly follow the linear grating formula, but deviates somewhat following a Bessel distribution. Nevertheless, for simplicity in this document we use the linear grating formula to express CCG periodicity on the understanding that a Bessel distribution is meant. Still further, it may be that deviations from a Bessel distribution can be used as a design parameter, e.g. for beam shaping or for controlling cavity losses. The effective refractive index for the radial mode is the net refractive index that is experienced by the radial mode taking account of its vertical distribution through multiple layers of the semiconductor heterostructure which will in general each have different refractive index values. The effective refractive index will also be affected by any in-plane variation of refractive index that may exist. These comments on grating periodicity are applicable to both the higher order grating and the optional first order grating.

It may be beneficial to provide a radial gap in between concentric subelements of the first and/or second order grating and/or between the first order grating and the higher order grating. The radial gap(s) have a radial extent equal to at least 2·λ / *n* and provide a gain section. The radial mode can therefore experience gain over the gain section without co-action of a grating. The radial extent of the gain section may be equal to at least several times the periodicity of the first order grating, for example, at least 2·λ / *n,* 3·λ / *n,* 4·λ / *n,* 5·λ / *n* or 10·λ / *n.* In some embodiments, the first order grating and/or the higher order grating may be subdivided into multiple subelements covering different ranges of radial extension, in which case there may be multiple radial gaps between the different subelements. If both a first order grating and a higher order grating are included, then these subelements may be radially interleaved with or without radial gaps between the subelements.

The higher order grating may incorporate a phase-shift, such as a π-shift, to affect the output beam profile. Moreover, in embodiments that include a first order grating, the first order grating may incorporate a phase-shift, such as a π-shift.

In most embodiments, the grating rings will be circular. However, it may be that the rings could be slightly oval, e.g. elliptical, to favour outcoupling of a certain polarization. Another possibility might be to have polygonal grating rings, e.g. octagon, decagon, dodecagon *etc.*

The grating structures for the higher order grating and optional first order grating may be formed by suitable lithography steps, in particular photolithography, optionally in combination with semiconductor overgrowth. These steps may involve etching, for example with wet or dry etching processes.

After growth of the semiconductor heterostructure, suitable electrodes are formed to allow for carrier injection into the active region. Typically, these will be formed by a suitable metal or metals, e.g. by depositing Au and Ti layers. However, other suitably conductive materials may be used, such as degeneratively doped semiconductors, as may be easy to do with the narrowband semiconductor materials used for ICLs. A pair of electrodes are jointly arranged to apply a voltage bias across the active region for current injection. Both electrodes may be fabricated from the top of the chip, with one electrode being deposited on the top surface and the other in a trench that extends to below the active region. A convenient shape for the trench is annular, i.e. circular. Moreover, it is convenient to arrange an annular trench to be at least approximately concentric with the grating rings. However, in principle, the trench could be any shape, e.g. square or polygonal, and also need not be centred on the centre of the grating rings.

Instead of fabricating both electrodes from the top of the chip, one electrode may be deposited on the top surface, i.e. on the top surface of the upper cladding, and the other on the bottom surface of the chip, i.e. on the underside of the substrate.

Embodiments are possible not only with the laser beam being coupled out through the chip surface, i.e. vertically upwards through the upper cladding layer (surface emission), but also with the laser beam being coupled out vertically downwards through the lower cladding layer and the substrate (substrate emission). Substrate emission cascade lasers have several potential advantages over surface emission casced lasers, namely:
- With a surface emission design, the top metallization layer used for electrical contacting is opaque at the emission wavelength, so that apertures in the metallization are needed to allow the laser emission. In a substrate emission design, no such apertures in the top metallization are needed, which allows for simpler fabrication, more efficient electrical pumping of the gain medium and better heat extraction from the top electrode.
- Substrate emission allows for epi-down mounting, i.e. the chip can be bonded by its top-surface onto the submount that carries the chip for packaging, this allowing for better heat extraction from the submount.
- Unlike the top surface, the chip's bottom surface, i.e. the underside of the substrate, is relatively unencumbered with features and so there is scope to incorporate extra features to provide additional functionalities. For example, optical structures may be incorporated on the bottom surface. An anti-reflection coating may be provided for reduced output losses and reduced parasitic back-reflections. Optical elements for beam shaping may be provided, such as diffractive optical elements, microlenses, prisms. The extra features may be realized by etching the bottom surface, by coating, by bonding or by overmolding, for example.
- Windowless-packaging: with substrate emission, the underside of the substrate acts as a window and can host additional optical elements. This can allow for cheaper and smaller-footprint packaging concepts, e.g. overmolding and chip-scale packages (CSP).

For surface emission, a top electrode may have an aperture to allow passage of the laser beam out of the laser without having to pass through the top electrode, e.g. an aperture that is annular and arranged co-concentrically with the grating rings. Alternatively, a transparent 'blanket' electrode may be provided, e.g. a thin degeneratively doped semiconductor layer.

The higher order grating couples out a component of the radial mode to form an output beam that propagates either in the vertical direction or with a component of its trajectory in the vertical direction. References in this document to a vertical emission cascade laser are therefore not limited to precisely vertical emission and also include emission of an output beam from the surface or substrate that propagates at an angle to the growth direction. In particular, when the higher order grating is a circular second order grating (including when provided in combination with a first order grating), the circular symmetry will ensure that all non-vertical components in the outcoupling interfere destructively, so that the output beam direction is vertical. On the other hand, with some higher order gratings, even when its rings are circular, the output beam may be at an angle away from vertical. An example is a circular third order grating.

When the higher order grating is second order, laser radiation will couple out of the active region bidirectionally, i.e. both upwards and downwards. In the case of a substrate emission design, the laser radiation that is coupled out upwards can be redirected downwards by reflection from the top electrode. The thickness of the upper cladding is then preferably specified such that, when the upwards outcoupled component that has been reflected back from the top electrode combines with the component that was outcoupled downwards, these two components interfere constructively. To deal with the same situation in a surface emission design, a DBR mirror could be fabricated below the active region. Also, in analogy to the substrate emission case, the DBR mirror should be located at an appropriate distance away from the active region to ensure constructive interference of the reflected component with the directly upwards outcoupled component when they combine.

When the higher order grating is third order, unidirectional emission may be possible, i.e. it may be possible to outcouple the laser radiation solely in the intended emission direction, i.e. upwards for surface emission and downwards for substrate emission.

It is noted that the lower cladding layer can be an integral part of the substrate, in which case a structurally distinct lower cladding layer is not present. This may be the case with a doped substrate.

The higher order grating may be configured to force the in-plane waveguide to support only a single radial mode, thereby to provide single mode laser action. Single mode operation will be the normal situation. However, the grating design might allow competition between lasing of multiple modes, especially at higher laser drive currents.

The higher order grating, and optional first order grating, can be formed by a refractive index contrast in a horizontal plane between portions of the upper or lower cladding layer where it is formed and an adjacent: metal layer; degenerately doped semiconductor layer; air; dielectric material (e.g. one used for encapsulation, such as a resin); and further layer of semiconductor material. In the case of a further layer of semiconductor material, that layer may be arranged at an interface of the upper cladding layer, i.e. by structure at the top of the upper cladding layer or at the bottom of the upper cladding layer, or by the further layer of semiconductor material being embedded within the upper cladding layer and having suitable in-plane structure. In embodiments with both a first order grating and a higher order grating, these could lie in different, vertically offset, horizontal planes, e.g. one could be formed by a refractive index contrast between two semiconductor materials at that bottom of the upper cladding layer, and the other could be formed by a refractive index contrast between the semiconductor material at the top of the upper cladding layer and a metal layer, a degenerately doped semiconductor layer, air or a dielectric material.

Embodiments in which the grating(s) are formed by structuring the top surface of the upper cladding layer in combination with air, metal or dielectric, have the advantage that the entire semiconductor growth of the layer stack can be completed before any lithographic steps need to be performed, thereby simplifying the fabrication process and also avoiding defect problems that may be caused by re-growth. In other words, etch and re-growth of semiconductor material is avoided. The only etching steps that are needed are from the top surface, namely the etch of the upper cladding layer to form the grating structure; and the etch of the trench. Since both etches are from the top surface, they take place after growth has been completed, i.e. after all semiconductor layers have been deposited.

It may be beneficial when the semiconductor layers are collectively configured so that the in-plane waveguide has a lower loss and/or higher gain central region and a higher loss and/or lower gain peripheral region in order to suppress propagation of waveguiding modes in the peripheral region of the in-plane waveguide and to promote propagation of waveguiding modes in the central region of the in-plane waveguide.

An in-plane variation of gain can be produced by restricting carrier injection to the central region, e.g. by suitable choice of the placement and extent of the electrodes. An in-plane variation of loss can be produced by providing higher loss material in the peripheral region, e.g. by depositing an absorber material around the semiconductor layer stack or by degrading the quality of one or more of the as *grown* semiconductor layers in the peripheral region, e.g. by ion bombardment, thereby to increase intrinsic losses in the as *grown* semiconductor layers. A non-circular shape of the periphery of the disk (e.g. a non-annular trench) can also be used to prevent formation of undesired peripheral optical modes and prevent constructively interfering reflections that could perturb the desired optical mode. A non-vertical etch of the periphery of the disk (i.e. the trench) may also be helpful for inhibiting constructively interfering reflections that could perturb the desired optical mode.

A wafer may be diced to provide individual lasers. Alternatively, the vertically emitting design lends itself to making one- or two-dimensional arrays of lasers. A laser array may therefore be provided that comprises a plurality of cascade lasers as described above that are formed monolithically as a single chip. This may be useful for combining multiple lasers in order to increase power output or power output density. This may also be useful for providing a laser array, where each laser has a different emission wavelength and is optionally individually drivable so that any laser in the array can be selected. The close packing of lasers with different emission wavelengths may also be useful for active infrared imaging or lidar (Light Detection and Ranging) applications.

To form a quantum cascade laser, the plurality of active region layers form a superlattice structure configured to provide gain through intraband transitions between quantum well subbands. The in-plane waveguiding action can be provided by refractive index contrast in the vertical direction between lower refractive index, lower and upper cladding layers, and a higher refractive index, active region. In-plane waveguiding confinement for the lasing mode(s) is therefore provided with sufficient overlap in the vertical direction with the gain medium of the active region.

To form an interband cascade laser, the plurality of active region layers form a superlattice structure configured to provide gain through interband transitions between quantum well subbands. The in-plane waveguiding action can be provided, for example, by refractive index contrast in the vertical direction between lower refractive index, lower and upper cladding layers and higher refractive index, lower and upper separate confinement layers and active region. In other words, the lower separate confinement layers are arranged between the active region and the lower cladding layer, and the upper separate confinement layers are arranged between the active region and the upper cladding layer. In-plane waveguiding confinement for the lasing mode(s) is therefore provided with sufficient overlap in the vertical direction with the gain medium of the active region.

According to another aspect of the invention, there is provided a method of manufacturing a cascade laser structure operable to emit a laser beam at a lasing wavelength, A, the method comprising:
providing a semiconductor substrate;
depositing a lower cladding layer on the semiconductor substrate (unless the substrate acts as the lower cladding in which case this step is not needed);
depositing a plurality of active region layers on the lower cladding layer to provide a gain medium for the cascade laser;
depositing an upper cladding layer on the active region layers, so that the lower cladding layer, active region layers and upper cladding layer collectively form an in-plane waveguide; and
structuring the upper or low er cladding layer to define a higher order grating of concentric rings that in use force the in-plane waveguide to support a radial mode having a substantial overlap with the gain medium and to couple out a component of the radial mode from the active region layers as the laser beam, the higher order grating being of order m in respect of the lasing wavelength, A, where m is at least 2.

### BRIEF DESCRIPTION OF THE DRAWINGS

This invention will now be further described, by way of example only, with reference to the accompanying drawings.
Figure 1A is a schematic cross-section of a QCL according to an embodiment of the invention using a second order CCG for outcoupling the laser emission through the substrate and for radial mode confinement.
Figure 1B is a schematic plan view showing the arrangement of the second order CCG of Figure 1A.
Figure 2A is a schematic cross-section of a QCL according to an embodiment of the invention using a second order CCG for outcoupling the laser emission through the substrate in combination with a first order CCG for radial mode confinement.
Figure 2B is a schematic plan view showing the arrangement of the first and second order CCGs of Figure 2A.
Figure 3A is a schematic cross-section of a QCL according to an embodiment of the invention using a second order CCG for outcoupling the laser emission through the substrate in combination with a first order CCG for radial mode confinement and a gain section in between.
Figure 3B is a schematic plan view showing the arrangement of the first and second order CCGs and the gain section of Figure 3A.
Figure 3C is a schematic plan view of a variant with a second order CCG subdivided into radially spaced subelements, each separated by a radial gain section.
Figures 4 to 13 are respective schematic cross-sections of QCLs according to further substrate emission embodiments of the invention.
Figure 14A is a schematic cross-section of a surface emission QCL according to an embodiment of the invention using a second order CCG for outcoupling the laser emission through the surface of the chip and for radial mode confinement (to be compared with the substrate emission embodiment of Figures 1A and 1B).
Figure 14B is a schematic plan view showing the arrangement of the second order CCG of Figure 14A in which shading is used to show the annular metallized part of the surface and non-shaded areas show a central circular aperture in the metallization to provide for surface emission.
Figure 14C is a schematic plan view of a variant of the surface emission embodiment of Figure 14A using a second order CCG for outcoupling the laser emission through the substrate in combination with a first order CCG for radial mode confinement (to be compared with the substrate emission embodiment of Figures 2A and 2B).
Figure 14D is a schematic plan view of a further variant of the surface emission embodiment of Figure 14A using a second order CCG for outcoupling the laser emission through the substrate in combination with a first order CCG for radial mode confinement as well as a radial gain section between the first and second order CCGs (to be compared with the substrate emission embodiment of Figures 3A and 3B).
Figure 15 is a schematic cross-section of a surface emission QCL according to an embodiment of the invention using a second order CCG for outcoupling the laser emission through the surface of the chip and for radial mode confinement (to be compared with the substrate emission embodiment of Figure 5).
Figure 16 is a schematic cross-section of an ICL according to an embodiment of the invention using a second order CCG for outcoupling the laser emission through the substrate and for radial mode confinement (to be compared with the QCL embodiment of Figure 1A).
Figure 17A is a schematic perspective view of a chip with a single laser according to embodiments of the invention.
Figure 17B is a schematic perspective view of a chip with a laser array of multiple lasers according to embodiments of the invention.

### DETAILED DESCRIPTION

In the following detailed description, we use the example of the higher order grating being a second order grating. It will be appreciated that in the following embodiments the higher order grating may be replaced with third or still higher order gratings.

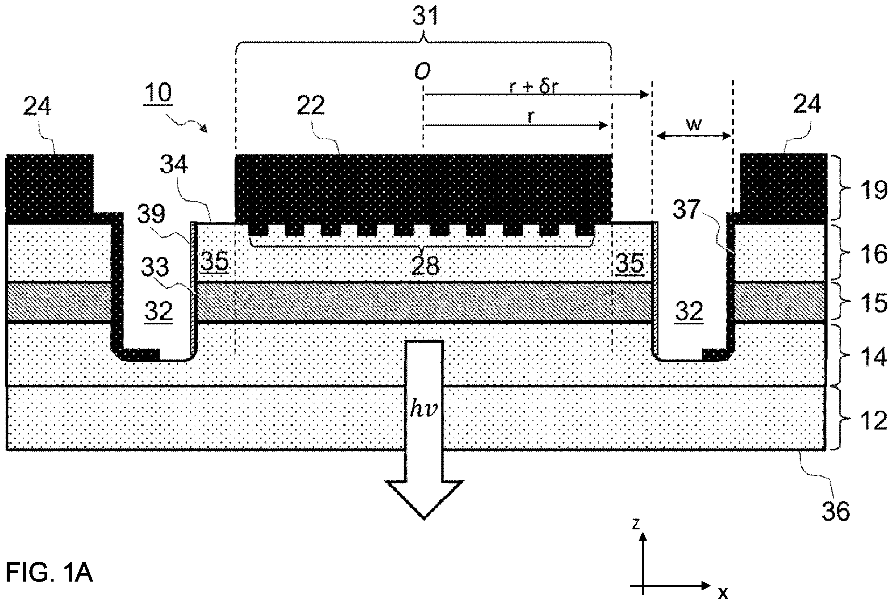

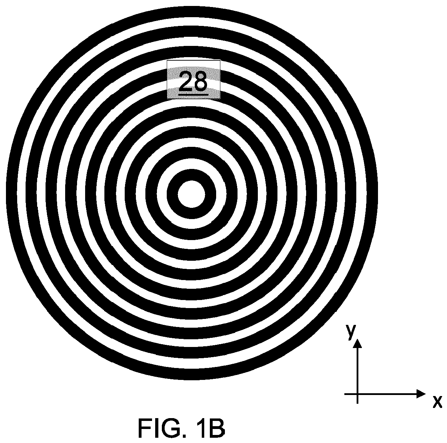

Figure 1A is a schematic cross-section of a QCL 10 according to an embodiment of the invention using a second order concentric circular grating (CCG) 28 centred around an origin point (in 2D) or axis (in 3D) which is labelled 'O'. for outcoupling the laser emission through the substrate and for radial mode confinement. Figure 1B is a schematic plan view showing the arrangement of the second order CCG of Figure 1A.

The semiconductor heterostructure is now described from the substrate upwards, i.e. in growth sequence of the layers. In a Cartesian coordinate system, the growth direction is the z-direction and the plane of the layers is an xy-plane. A doped substrate 12 is provided, e.g. from doped InP. A lower cladding layer 14, which may also be considered as a buffer layer, is deposited on the substrate 12, e.g. of doped InP. The layers for the active region 15 are then deposited including a sequence of layers formed by alternating deposition of different bandgap materials to form a superlattice structure, e.g. two materials selected from the materials system InGaAIAsP to be lattice matched to InP - most commonly InGaAs/AlInAs. Since the active region layer design is standard, its individual layers are not shown to avoid overcomplicating the drawing. An upper cladding layer 16, e.g. of InP, then follows to complete the semiconductor heterostructure, which thus terminates at a top surface 34. The bottom of the semiconductor heterostructure is formed by the bottom surface 36 of the substrate. An in-plane waveguiding region is thus formed by refractive index contrast in the vertical direction between lower refractive index, lower and upper cladding layers 14 and 16, and a higher refractive index, active region layers 15. After growth of the semiconductor heterostructure, the chip is subjected to lithographic processing to form the CCG 28 and the necessary contacts for biasing across the active region to provide carrier injection. A circular area on the top surface 34 is structured by etching concentric circles into a small depth portion of the upper cladding layer 16 to form concentric rings. This may be done using suitable lithographic process steps. In vertical section through a diameter of the concentric rings, the structuring has the form of crenellations as illustrated. An annular trench 32 of width 'w' is etched into the top surface 34 through the upper cladding layer 16 and active region 15 and partway through the lower cladding layer 14. The annular trench 32 encloses the CCG 28. The trench 32 therefore forms an outwardly facing side surface 33 in the form of a cylinder surface of radius 'r + δr' about a cylindrical axis '*O*', an inwardly facing side surface 37 in the form of a cylinder surface of radius 'r + δr + w' and a trench base.

Metallization is then performed not only to provide the two biasing contacts, but also to fill the concentric circular indentations (crenellations in section) and thereby create a radial modulation of refractive index in the plane of the concentric circular indentations (crenellations in section), as required for the intended grating to refract. A layer of metal 19 is deposited on the upper surface 34. This metal forms not only a circular top contact 22 of radius 'r' over the portion of the top surface 34 situated radially inside the annular trench 32, but also metal for a lateral contact 24. Through suitable lithography steps, e.g. lift-off, metal can be deposited to fill a radially outer part of the annular trench 32 and form a contiguous element with the part of the metal layer 19 that is located radially outside the annular trench 32, thereby to form a lateral contact 24 for applying a voltage to the active region layers from below that is electrically separate from the top contact 22. Emission is in the downward direction through the substrate 12 as indicated schematically by the arrow labelled *hv.*

It can be seen in Figure 1A that the top contact 22 does not radially extend to the outwardly facing side surface 33 of the layer stack 14, 15, 16 that forms an in-plane waveguide region. Rather, there is a peripheral region 35 not covered by the top contact 22 which surrounds a central region 31 covered by the top contact 22. The in-plane waveguide is thus subdivided into a higher gain central region 31 and a lower gain peripheral region 35. This has the effect of suppressing propagation of waveguiding modes in the peripheral region 35 and promoting propagation of waveguiding modes in the central region 31. It will be understood that this gain difference is a result of waveguiding in the peripheral region 35 being passive, since there is no current injection from the top contact 22 (making the simplifying assumption of purely vertical carrier movement) or more accurately taking account of lateral current spreading much reduced current injection compared with to the central region 31 lying directly below the top contact 22. The peripheral region 35 is thus relatively lossy for wavelengths that are waveguided by the waveguiding layer stack 14, 15, 16 in comparison to the area under the top contact 22 where carrier injection provides for high gain. The peripheral region 35 has the beneficial effect of helping to suppress lasing of undesired modes, such as whispering gallery modes, and to reduce radially inward back reflection from the waveguide stack's side surface 33. An optional anti-reflection coating (ARC) 39 is also shown, e.g. with Al₂O₃. The ARC 39 is deposited on the waveguide stack's outer surface 33 to reduce radially inward back reflection of waveguiding modes. The ARC 39 could be a single layer or a multi-layer coating.

It will be understood that although the cladding layers 14 and 16 are illustrated and described as single layers, they may be formed by multiple layers. Moreover, the substrate 12 may serve as the lower cladding layer 14, in which case a separate lower cladding layer would be omitted.

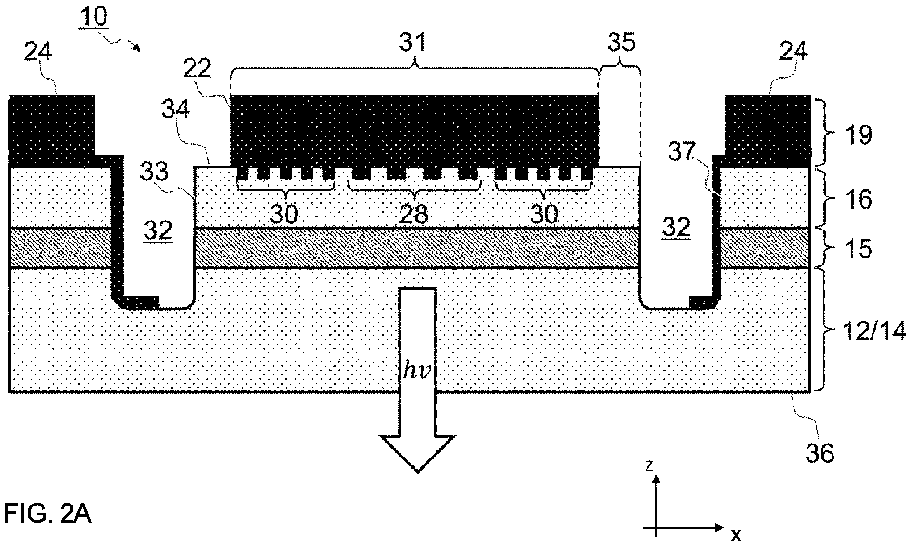

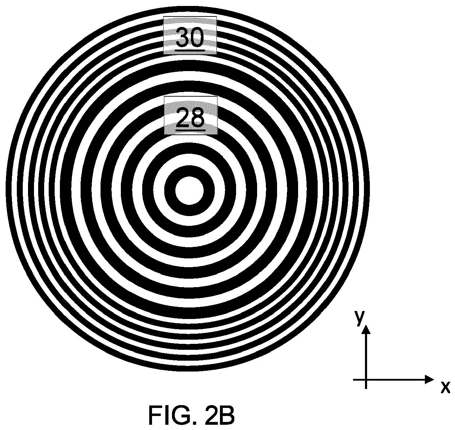

Figure 2A is a schematic cross-section of a QCL 10 according to an embodiment of the invention using a second order CCG 28 for outcoupling the laser emission through the substrate in combination with a first order CCG 30 for radial mode confinement. Figure 2B is a schematic plan view showing the arrangement of the first and second order CCGs 30, 28 of Figure 2A. The embodiment of Figures 2A and 2B differs from that of Figures 1A and 1B only in two respects. First, as foreshadowed above, the substrate 12 also serves as the lower cladding layer 14, so a separate lower cladding layer 14 is not present. Second, the grating design is different. Namely, an additional first order grating 30 is arranged radially outside the second order grating 28. The first order grating 30 has the function of causing in-plane reflection of the radial lasing mode, thereby assisting the formation of a standing wave within the cylindrical volume formed by the radial extent of the gratings and the depth of the waveguiding region (cladding and active region layers 14, 15, 16). In variants of this embodiment, the first order grating 30 could be arranged sandwiched, i.e. interposed, between a radially inner and a radially outer part of the second order grating 28. Another variant would be to have the first order grating 30 arranged radially inside the second order grating 30. Indeed, it can be advantageous to place the first order grating 30 close to the centre to control the vertical outcoupling and thereby the cavity losses, and to place the second order grating 28 radially outside the first order grating 30, to provide a lower beam divergence of the output beam. (This statement also applies to embodiments which use a higher than second order grating.)

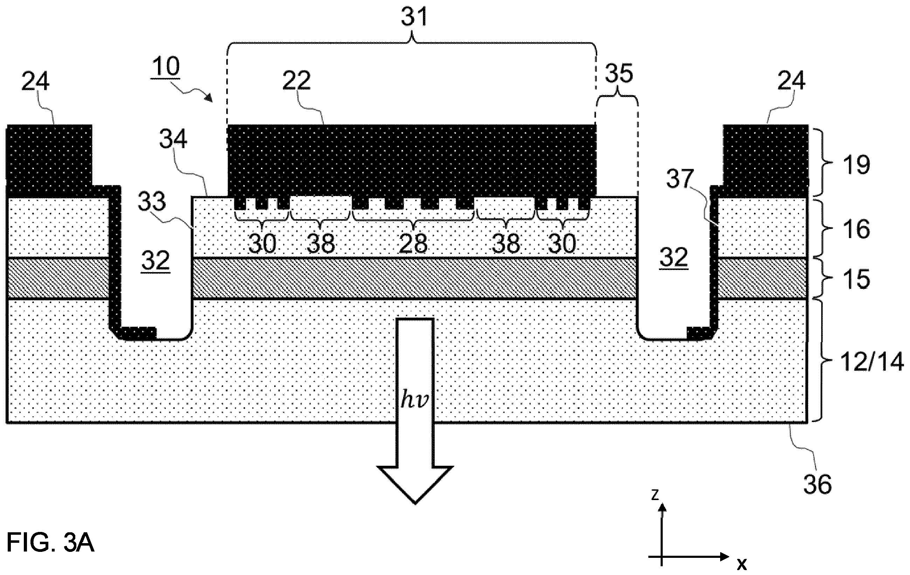

Figure 3A is a schematic cross-section of a QCL 10 according to an embodiment of the invention using a second order CCG 28 for outcoupling the laser emission through the substrate in combination with a first order CCG 30 for radial mode confinement, as well as a gain section 38 arranged in between them.

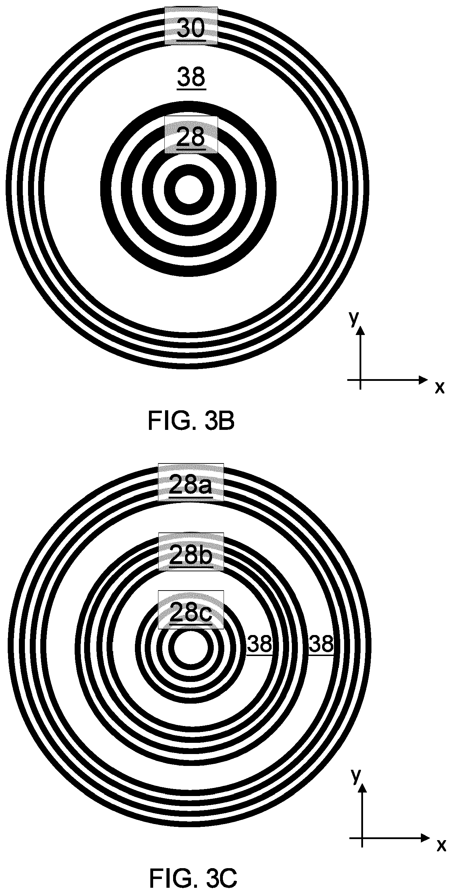

Figure 3B is a schematic plan view showing the arrangement of the first and second order CCGs and the gain section of Figure 3A. The embodiment of Figures 3A and 3B has a different arrangement of the gratings 28, 30 compared to Figures 2A and 2B. Namely a radial gap exists between the radially outer first order grating 30 and the radially inner second order grating 28. The gap acts as a gain section 38 between the second and first order gratings 28, 30. It is also noted that a separate lower cladding layer 14 is provided in the same way as in the embodiment of Figures 1A and 1B. In variants of this embodiment, the gain section 38 could be radially inside both the first and second order gratings 30, 28. In other variants, the sequence of these features from the centre outwards could be gain section 38, first order grating 30, second order grating 28.

Figure 3C is a schematic plan view of a variant in which the second order CCG 28 is subdivided into radially spaced subelements 28a, 28b, 28c, each separated by a radial gain section 38. In a further variant, the subelement 28b could be substituted with a first order grating 30.

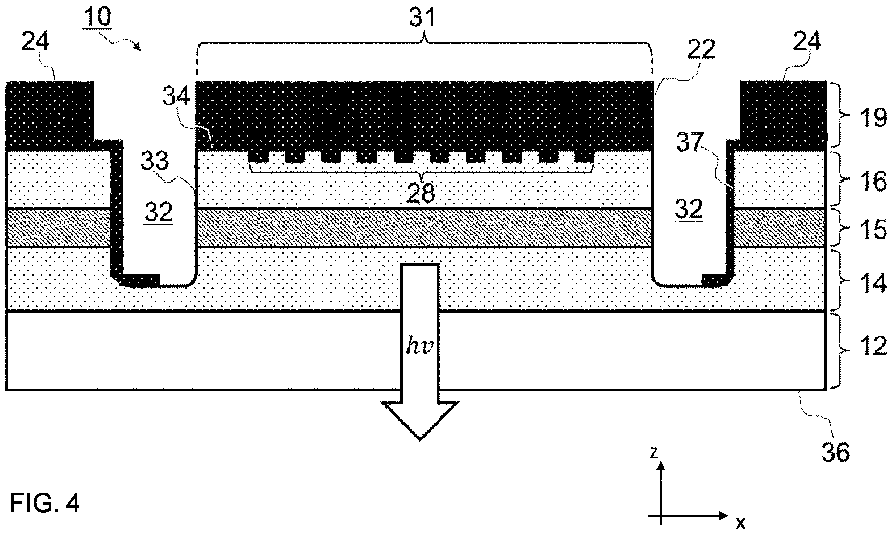

Figures 4 to 13 are respective schematic cross-sections of QCLs 10 according to further embodiments of the invention, all of which couple out the laser emission through the substrate. These embodiments are described by way of highlighting differences from preceding embodiments. It is also noted that all of Figures 4 to 13 show a grating design the same as in the embodiment of Figures 1A and 1B, but can each be varied to incorporate the grating design of Figures 2A and 2B, or Figures 3A and 3B.

Figure 4 shows an embodiment that has a nominally undoped (or low doped) substrate 12 instead of the doped substrates of the previous embodiments. Nominally undoped or low doped may, for example, mean a doping concentration of less than 1e16 cm-3. For a substrate emission design as shown, having a substrate with no or little intentional doping will minimize the absorption of the laser light as it passes through from the active region layers after refraction from the grating. The lower cladding layer 14 formed on the substrate 12 is doped, as is the upper cladding layer 16. In Figure 4, the option of forming the top contact 22 up to the trench 32, i.e. up to vertical alignment with the trench side surface 33, is also shown, so that in this embodiment carrier injection takes place substantially equally across the full horizontal extent of the in-plane waveguide.

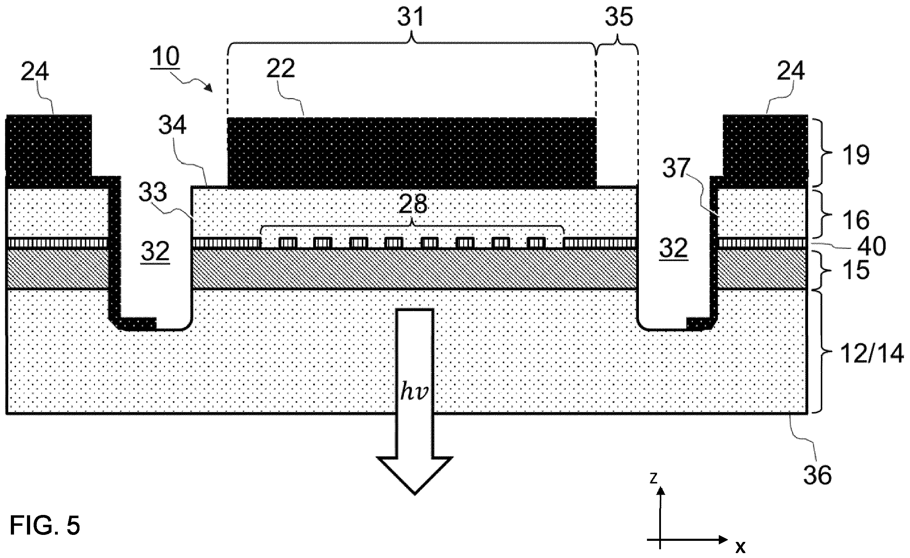

Figure 5 shows an embodiment with a different way of fabricating the second order grating 28. Instead of forming the second order grating 28 by etching into the top surface 34 and metal infilling, the second order grating 28 is formed as a layer 40 buried within the semiconductor heterostructure. After completion of the growth of the active region layers, a layer of semiconductor material is deposited. The layer is then selectively removed by patterning and etching in a circular central area to leave the layer 40 as illustrated. The structured surface is then overgrown by the upper cladding layer 16 to form the second order grating 28. What is important for the formation of the second order grating 28 is a refractive index difference between the semiconductor material of the grating layer 40 and the semiconductor material of the upper cladding layer 16, so the semiconductor material of the layer 40 could have lower or higher refractive index than that of the upper cladding layer 16. It is also noted that the doped substrate 12 also serves as the lower cladding layer 14 in this embodiment. In variants of this embodiment, a first order grating 30 may be included co-planar with the second order grating 28. The first order grating 30 may be arranged radially outside or inside the second order grating 28, or in a sandwich arrangement as discussed further above. Another option would be to form a first order grating 30 in a separate plane by structuring the upper suface of the upper cladding layer 16 in combination with metal infill from the top electrode 22 (i.e. as shown in Figure 2A). This shows that embodiments are possible in which the first order grating and second order grating are formed in different planes vertically offset from one another.

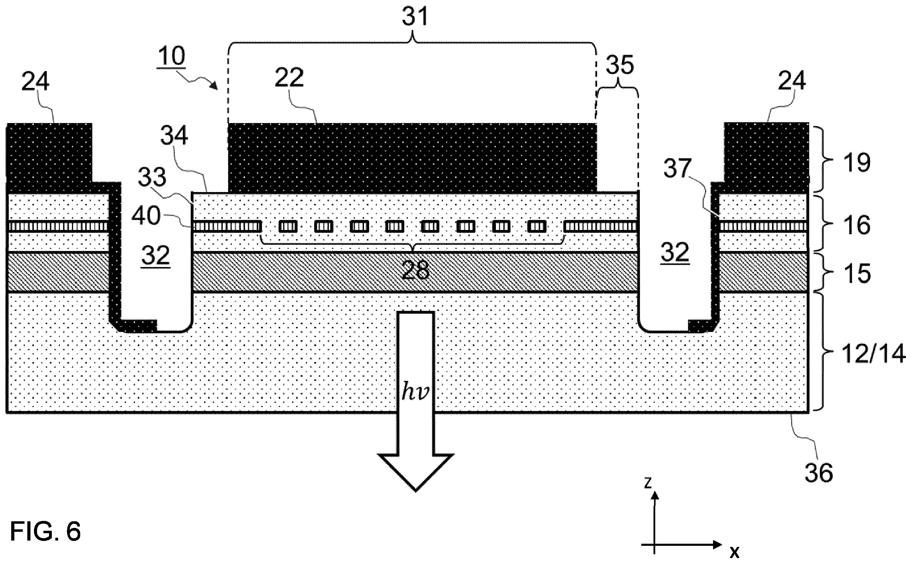

Figure 6 shows an embodiment which differs from that of Figure 5 only in that the grating layer 40 is formed part way up the upper cladding layer 16. During the crystal growth, after completion of the active region layers, a portion of the upper cladding layer 16 is deposited, then the grating layer 40. After structuring the grating layer 40, growth of the upper cladding layer 16 is continued.

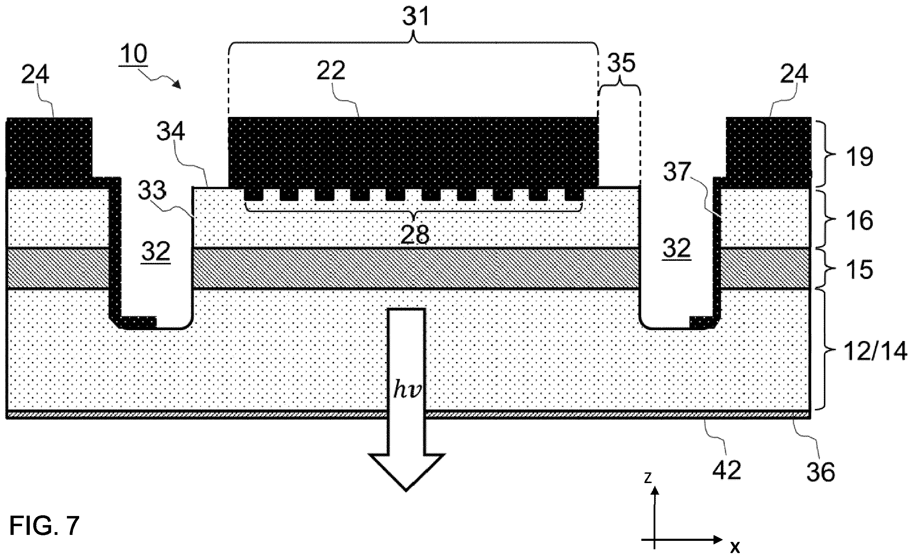

Figure 7 shows an embodiment that is the same as that of Figures 1A and 1B, except that an anti-reflection coating 42 is deposited on the bottom surface 36 of the substrate to reduce output losses and reduce back reflections which may cause instabilities in the laser operation.

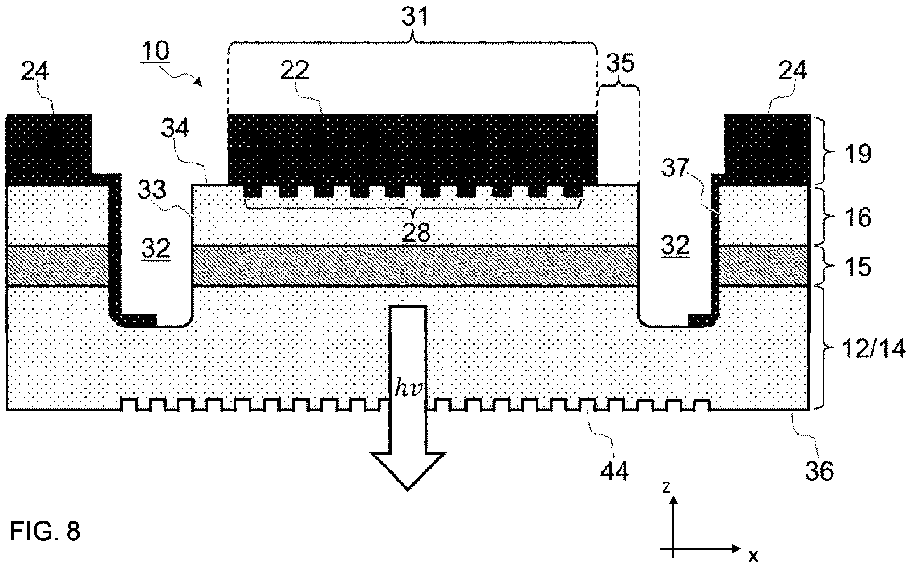

Figure 8 shows an embodiment that is the same as that of Figures 1A and 1B, except that structure is etched into the bottom surface 36 of the substrate to form an integrated optical element 44, for example a diffractive optical element (DOE) or some other component for beam shaping or modifying the laser emission.

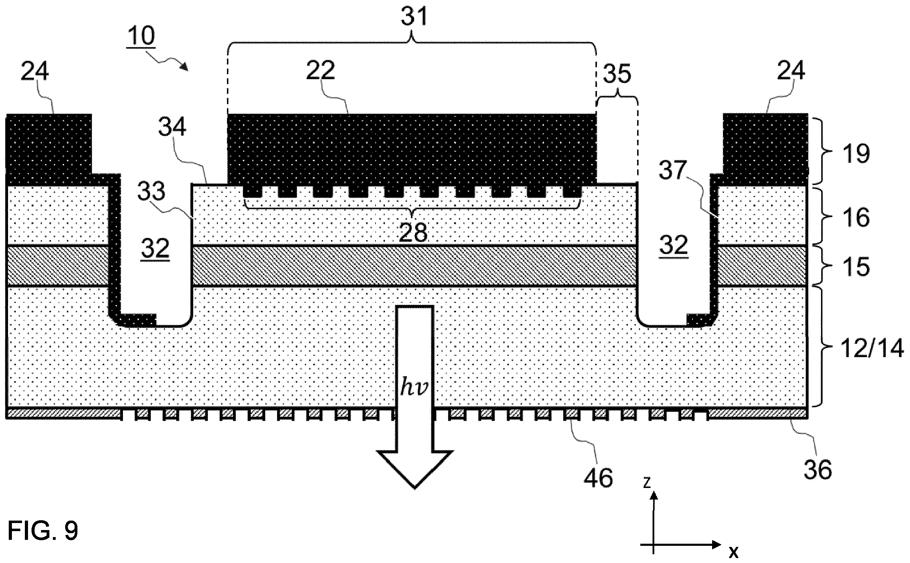

Figure 9 shows an embodiment that is the same as that of Figures 1A and 1B, except that an additional layer or layers are formed on the bottom surface 36 of the substrate to form an integrated optical element 46. The extra layer(s) may be formed by deposition, bonding, transfer moulding or some other method.

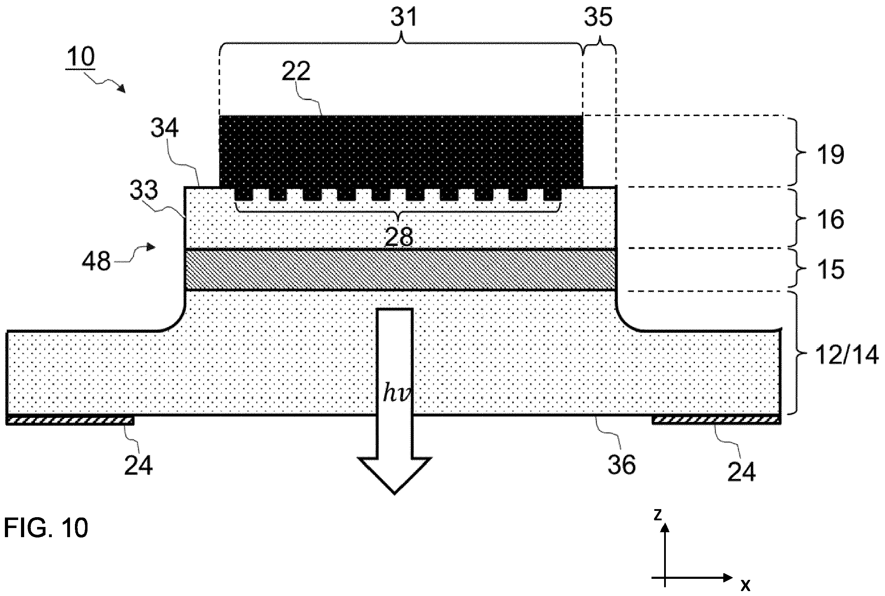

Figure 10 shows an embodiment that has the same layer sequence as that of Figures 2A and 2B. The provision of a doped substrate 12 allows a bottom contact 24 to be deposited on the bottom surface 36 of the substrate 12, as an alternative to the lateral contact of previous embodiments, thereby obviating the need for the annular trench design of the previous embodiments. A doped substrate may have a doping concentration of greater than 1e17 cm-3, for example. The chip is etched into a mesa form 48 to guide the carrier injection into the active region, with the mesa extending through the upper cladding layer 16, the active region 15 and part way through the substrate 12. The bottom contact 24 has an aperture to allow for downward laser emission through the substrate 12.

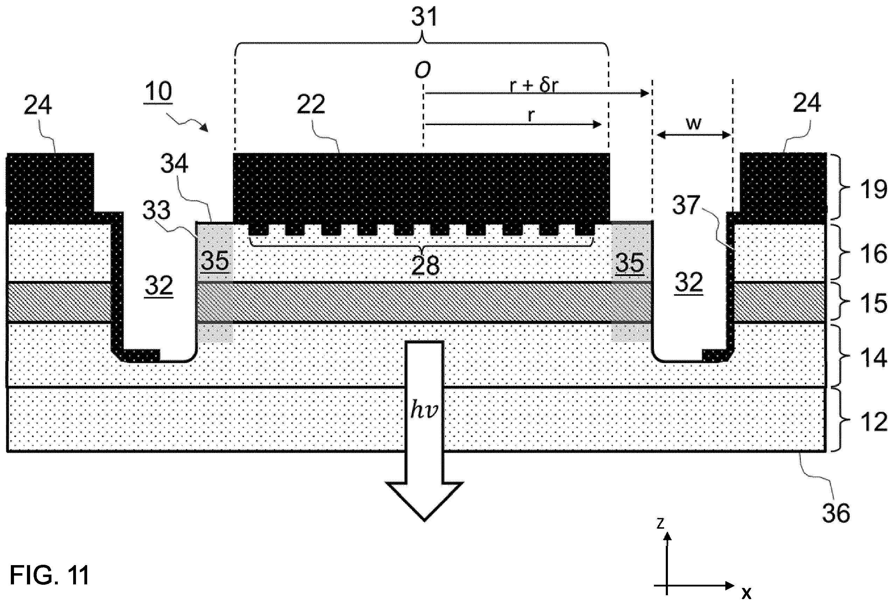

Figure 11 shows an embodiment that is the same as that of Figures 1A and 1B except that at least a portion of the peripheral region 35 lying radially between the outside of the grating structure 28 (or 28 and 30) and the waveguide stack's side surface 33 is formed of a higher absorbing, i.e. lossier, material in order to enhance suppression of waveguiding modes that are not desired, such as whispering gallery modes, and to reduce back reflection from the side surface 33. The lossy region 35 can be made to have higher losses, i.e. to be more absorbent to photons with wavelengths that are waveguided by the waveguiding layer stack 14, 15, 16 than is the case for the as *grown* layers 14, 15 and/or 16 through post-processing. A suitable method is ion bombardment from above using the top contact 22 as a shadow mask. The lossier material extends vertically through at least a part of the depth of the waveguide stack, i.e. over at least part of the depth of layers 16, 15 and 14, as schematically illustrated with the shading that extends through layers 16 and 15 and part way into layer 14. In this embodiment, there is not only a gain difference between the central and peripheral regions 31, 35 as a result of the locality of the current injection into the gain region but also an absorption difference as a result of the lossier material that is incorporated in the peripheral region 35. The in-plane waveguide thus has a lower loss and higher gain central region 31 and a higher loss and lower gain peripheral region 35. It will be further understood that for embodiments such as that of Figure 4 it is possible to include lossy material to provide differential losses as just described, even though gain may be the same across the whole in-plane waveguide.

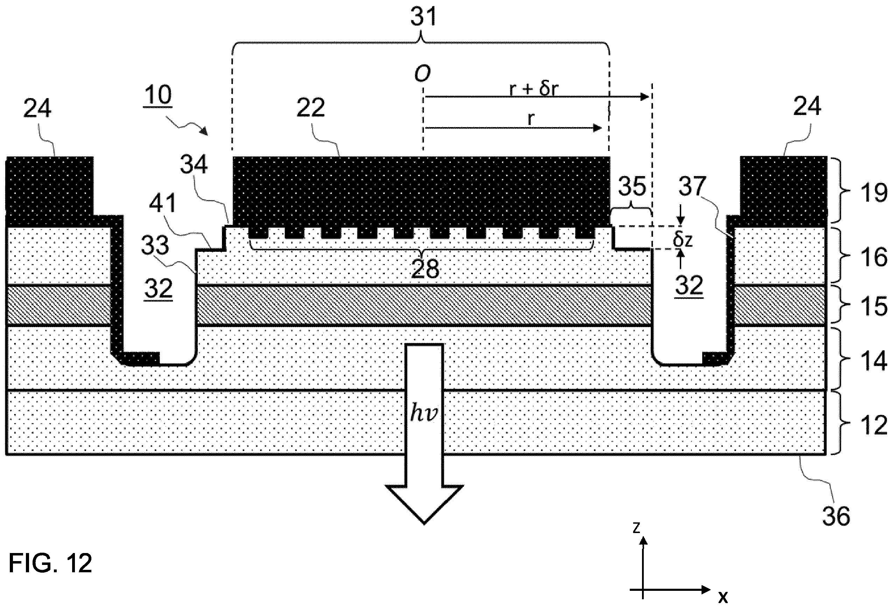

Figure 12 shows an embodiment that is the same as that of Figures 1A and 1B except that a step 41 of depth 'δz' is etched away from the top surface 34 in the peripheral region 35. The effect of this additional etch is to remove an upper part of the upper cladding layer 16 from the peripheral region 35, so that any lateral current spreading that may have otherwise occurred into that upper part can no longer take place, thereby enhancing the loss effect of the peripheral region 35.

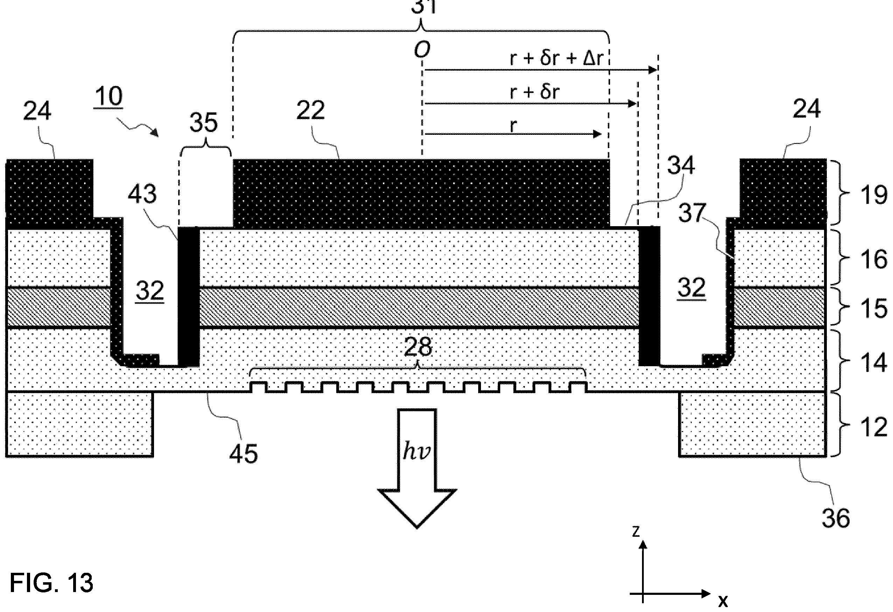

Figure 13 shows an embodiment that is similar to that of Figures 1A and 1B. One difference is that a ring 43 of additional lossy material of radial thickness 'Δr' is deposited on the waveguide stack's side surface 33, i.e. the inner trench surface, thereby to enhance the losses further in the peripheral region 35. The ring of lossy material could be formed by an etch and semiconductor regrowth process before trench formation as the layers are being epitaxially deposited, or after growth by depositing an extra ring of lossy material on the stack's side surface 33 after trench formation. In the latter case, any suitable lossy material could be used including polymers, photoresist and adhesives. It will thus be understood that provision of a peripheral lossy region 35, 39 may provide useful measures to ensure single mode operation of the desired radial mode (or multiple desired radial modes in case of a multi-mode design). This approach is applicable in all embodiments described herein, not just the specific designs illustrated in Figures 11 to 13. Another difference compared to Figures 1A and 1B is that the substrate is etched away locally over the area enclosed by the trench 32 to expose the lower surface 45 of the lower cladding layer 14 and this lower surface 45 is structured to form the grating 28.

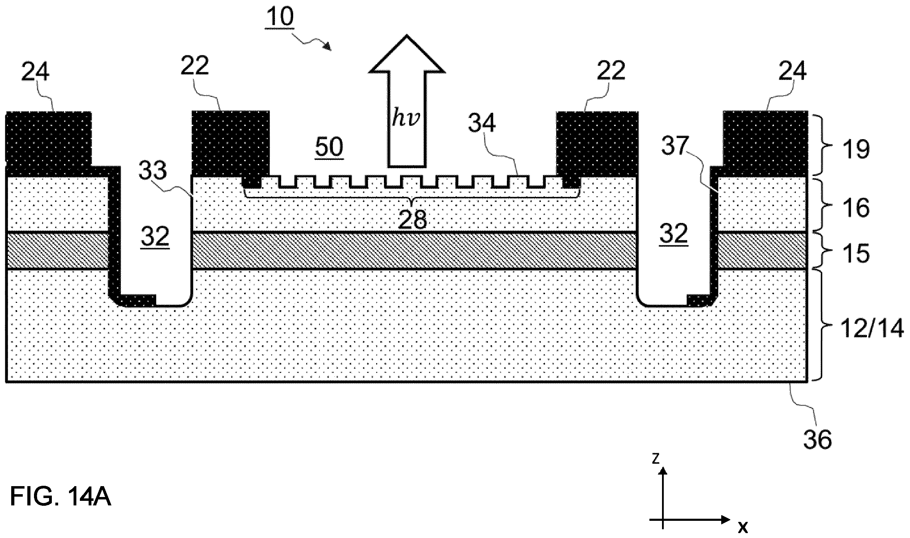

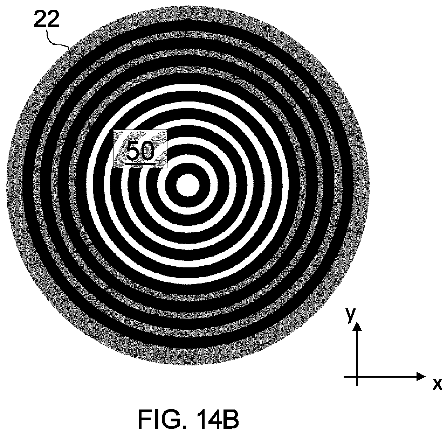

Figure 14A is a schematic cross-section of a surface emission QCL 10 according to an embodiment of the invention using a second order CCG 28 for outcoupling the laser emission through the surface of the chip and for radial mode confinement. Figure 14B is a schematic plan view of Figure 14A. This embodiment is to be compared with the substrate emission embodiment of Figures 1A and 1B. The top contact 22 is annular in form, thereby creating a circular aperture 50 to allow for laser emission through the top surface 34. Figure 14B uses shading to show the annular metallized part of the surface and non-shaded areas to show the central circular aperture 50. The aperture 50 is shown extending radially over a central portion of the grating 28, a rim portion of the grating 28 being covered by the metallization of the top contact 22. In variants of this embodiment, the aperture 50 could uncover the whole grating 28.

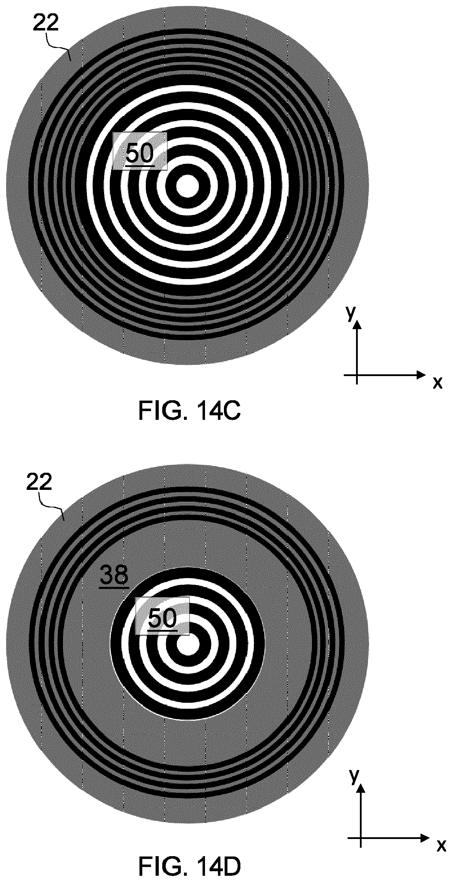

Figure 14C is a schematic plan view of a variant of the surface emission embodiment of Figure 14A using a second order CCG 28 for outcoupling the laser emission through the surface in combination with a first order CCG 30 for radial mode confinement (to be compared with the substrate emission embodiment of Figures 2A and 2B). Shading is used to show the annular metallized part of the surface and non-shaded areas to show a central circular aperture in the metallization to provide for surface emission.

Figure 14D is a schematic plan view of a further variant of the surface emission embodiment of Figure 14A using a second order CCG 28 for outcoupling the laser emission through the surface in combination with a first order CCG 30 for radial mode confinement as well as a radial gain section 38 between the first and second order CCGs (to be compared with the substrate emission embodiment of Figures 3A and 3B). Shading is used to show the annular metallized part of the surface and non-shaded areas to show a central circular aperture in the metallization to provide for surface emission.

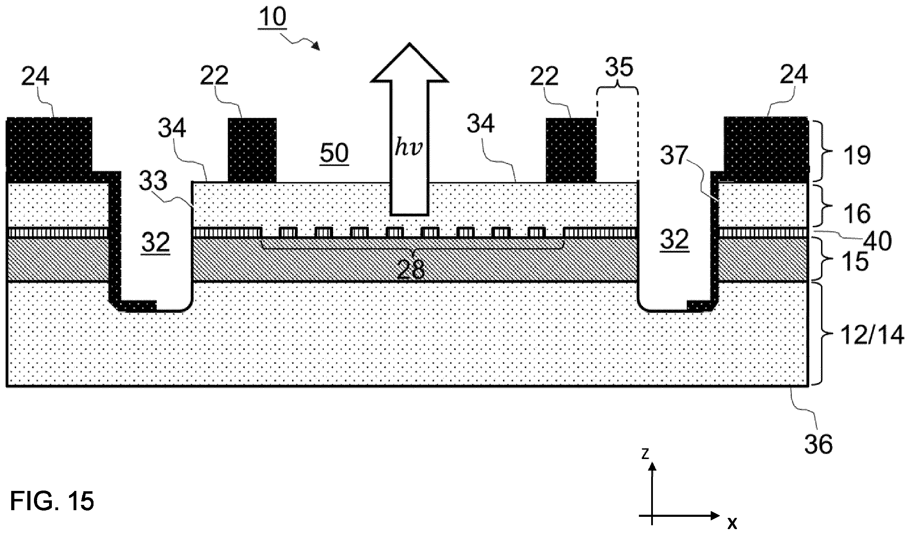

Figure 15 is a schematic cross-section of a surface emission QCL 10 according to an embodiment of the invention using a second order CCG 28 for outcoupling the laser emission through the surface of the chip and for radial mode confinement. This embodiment is to be compared with the substrate emission embodiment of Figure 5. The top contact 22 is annular in form, thereby creating a circular aperture 50 to allow for laser emission through the top surface 34. In plan view, the top electrode 22 is arranged in relation to the CCG 28 similarly to as shown in Figure 14B. Variants as shown in Figure 14C and Figure 14D are also possible.

It will be appreciated that the different features of the QCL embodiments of Figures 1 to 15 can be combined in many permutations to provide further QCL embodiments that mix these features.

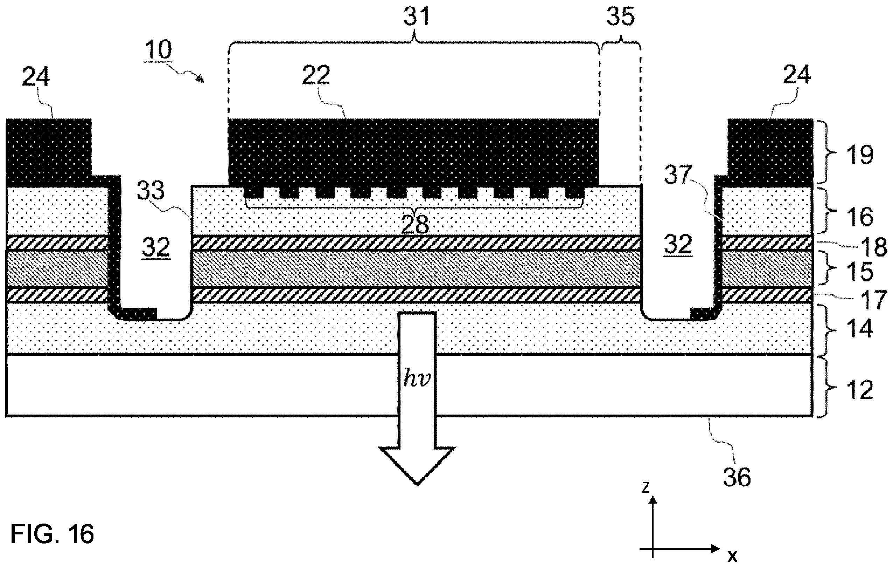

Figure 16 is a schematic cross-section of an ICL 10 according to an embodiment of the invention using a second order CCG 28 for outcoupling the laser emission through the substrate and for radial mode confinement. This embodiment is to be compared with the QCL embodiment of Figure 1A. In an ICL, as compared to a QCL, the waveguiding is produced differently, since the active region 15 will not generally have a high enough refractive index relative to the cladding layers 14, 16. In order to provide in-plane waveguiding and hence sufficient overlap between the waveguiding mode(s) and the gain medium provided by the active region 15, there are provided lower and upper separate confinement layers (SCLs) 17 and 18. The SCLs 17 and 18 are of higher refractive index and provided either side of the active region 15. The substrate 12 may be GaSb, either undoped as schematically shown or n-type. The SCLs 17 and 18 may be formed n-doped GaSb. The cladding layers 14, 16 are lightly doped n-type and may be of bulk alloy AIGaAsSb that is lattice matched to GaSb, i.e. the substrate material, or InAs/AISb superlattices. The active region of an ICL are an active quantum well (QW) part, a hole injector part, and an electron injector part. The active QW part may be formed by InAs/GaInSb QWs. The hole injector part may be formed by coupled GaSb/AlSb QWs. The electron injector part may be formed of coupled InAs/AISb QWs. In an ICL, in view of the narrow bandgap materials, it may also be convenient for the top contact material 19 to be a degeneratively doped semiconductor instead of a metal, e.g. n+ doped InAs(Sb).

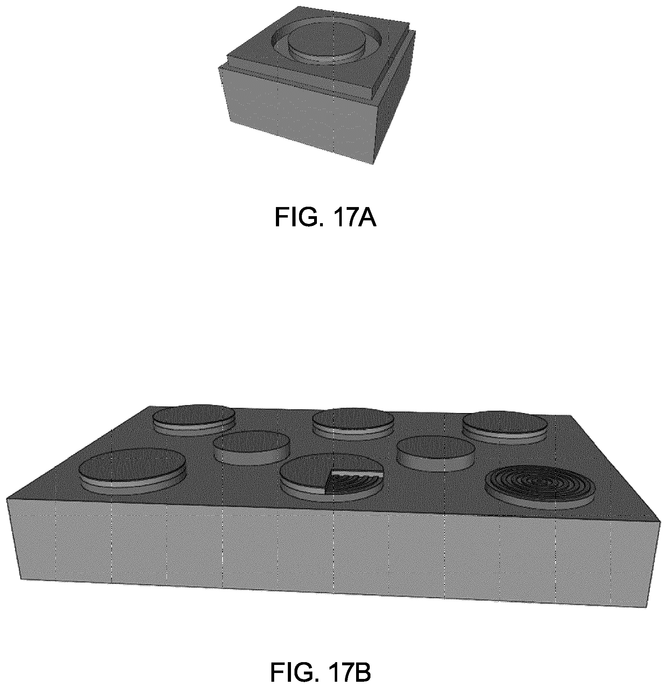

Figure 17A is a schematic perspective view of a chip with a single laser according to embodiments of the invention.

Figure 17B is a schematic perspective view of a chip with a laser array of multiple lasers according to embodiments of the invention. Partial cut-aways of two of the lasers are illustrated to show the grating structure. A 2D array of lasers are shown with an offset packing. In other embodiments, the packing may be according to a square grid, or in concentric circles. In other embodiments, the array may be a 1D array, e.g. arranged in a line or circle.

General aspects of the second order grating design, and the first order grating design, are now discussed that are applicable to all of the above embodiments.

The periodicity Λ of a linear grating of order m is Λ = *m·*λ / 2*·n.* The periodicity for a second (m=2) order linear grating is therefore *λ* / *n.* However, due to the circular geometry of the resonator, the optimal periodicity of the second order grating is not constant as for a linear grating but varies slightly in the radial direction following a Bessel distribution. The condition for the second order grating to control the vertical emission is to allow for a wavevector in the vertical direction while, for the lateral confinement, the second order grating needs to allow for a wavevector in the plane. (The same can be generalized for all higher orders, i.e. all *m* ≥ 2.)

Even though the theoretically optimum designs for achieving these conditions are quite clear, i.e. following a Bessel distribution, deviations from the theoretical ideal may be exploited to engineer other desirable properties of the laser. These deviations and their effects on performance would be explored through simulations at the design stage. In particular for the vertical extraction, the second order grating positions can be shifted, at least over a part of the grating, away from the theoretical optimum so as to provide effects such as: to provide more or less outcoupling (which may be desirable to tune according to how much gain is present), to favour emission of a certain polarization, or to attain a certain desired far field distribution of the emitted beam. Whatever deviations from the optimum are used, the second order grating must allow a component of the wavevector in the vertical direction, so that outcoupling is achieved.

The periodicity for a first (m=1) order linear grating is therefore λ / 2·*n* (i.e. half that of the second order grating). However, like the second order concentric ring grating, the optimal periodicity for the first order grating is not exactly constant as it would be for a linear grating, but varies slightly in the radial direction following a Bessel distribution.

There is no particular minimum or optimum number of grating rings as a generality. The number of rings that are needed depends on factors such as the refractive index contrast in the plane of the grating and whether a first order grating is provided in addition to a second order grating. A typical minimum number of rings for good performance might be 10-20. A typical number of rings might be anywhere from the minimum up to perhaps 50-100.

For any of the above embodiments, the following general comments apply.

Typical emission wavelengths for QCL and ICL embodiments of the invention are 2 to 20 micrometers.

Suitable semiconductor materials systems for fabrication are GaAIAs (sometimes referred to as arsenide-based), GaAlInAsP (sometimes referred to as phosphide-based), and GaAlInAsSb (sometimes referred to as antimonide-based). Suitable electrode materials include Ge and the metals Au, Ti, Ni and Pt.

The upper and lower cladding layers are typically n-type doped. The active region layer sequence may be grown in either an np or pn sequence. Consequently, in different embodiments the biasing for current injection across the contacts, i.e. across the top and lateral contact or across the top and bottom contact, may be in either sense. Most commonly for a QCL and ICL the upper and lower claddings are both n-type and the top contact is the negative contact.

The active region for forming the QCL or ICL can follow any known design. For this reason, the precise layer sequence of the active region has not been described in detail. For QCLs, the most common designs are bound-to-bound, bound-to-continuum and continuum-to-continuum.

The gratings are formed lithographically with an etch and optionally also a fill. A semiconductor layer is etched and then the gaps in that layer are filled with a suitable semiconductor material or metal (or metallic) material to provide the necessary in-plane refractive index contrast. To define a mask for the grating, UV or deep-UV lithography may be used, or alternatively e-beam lithography. The etch may be wet or dry, *e.g.* by reactive ion etching. For embodiments that have semiconductor-semiconductor gratings, more fabrication details can be found in Kapsalidis *et* al 2018 [5]. For embodiments that have semiconductor-metal gratings, more fabrication details can be found in Wu *et* a/2017 [6].

For substrate emission embodiments, integrated optical elements can be provided on the underside of the substrate. Optical elements may be fabricated, for example, by directly etching the surface of the substrate, by etching material(s) layer(s) deposited on the substrate or even by attaching a pre-fabricated optical element to the substrate, such as be transfer molding. The optical elements can be for example lenses (including microlenses), polarizing elements, beam steering elements, wavefront shaping elements.

For substrate emission embodiments, the substrate may be partially or wholly etched away below the second order grating to reduce absorption losses. In this configuration, the grating(s) could also be formed on the lower surface of the lower cladding which would be exposed by the substrate etch.

It will be clear to one skilled in the art that many improvements and modifications can be made to the foregoing exemplary embodiment without departing from the scope of the present disclosure.

### REFERENCE NUMERALS

- 10: cascade laser, QCL or ICL
- 12: substrate
- 14: lower cladding layer (buffer layer)
- 15: active region (multiple layers)
- 16: upper cladding layer
- 17: lower separate confinement layers (in an ICL)
- 18: upper separate confinement layers (in an ICL)
- 19: top metal structure
- 20: bottom metal structure
- 22: top contact
- 24: lateral or bottom contact
- 28: second order concentric circular grating
- 30: first order concentric circular grating
- 31: low loss / high gain central region
- 32: trench for contact formation
- 33: outwardly facing side surface of trench (or waveguide layer stack)
- 34: top surface of semiconductor heterostructure
- 35: high loss / low gain peripheral region
- 36: bottom surface of semiconductor heterostructure
- 37: inwardly facing side surface of trench
- 38: radially extending gain section between second and first order ring gratings
- 39: anti-reflection coating
- 40: semiconductor grating material layer
- 41: etch step
- 42: anti-reflection coating
- 43: lossy material ring
- 44: integrated optics substrate surface structure
- 45: exposed lower surface of lower cladding layer
- 46: integrated optics layer
- 48: mesa
- 50: top contact aperture
- 52: chip with single laser
- 54: chip with laser array

### REFERENCES

1. M. J. Süess et al., "Single-Mode Quantum Cascade Laser Array Emitting From a Single Facet," in IEEE Photonics Technology Letters, vol. 28, no. 11, pp. 1197-1200, 1 June1, 2016, (doi: https://doi.org/10.1109/LPT.2016.2533443)
2. R. Szedlak, C. Schwarzer, T. Zederbauer, H. Detz, A. Andrews, W. Schrenk, and G. Strasser, "Grating-based far field modifications of ring quantum cascade lasers," Opt. Express 22, 15829-15836 (2014) (doi: https://doi.org/10.1364/OE.22.015829)
3. Mahler, L., Tredicucci, A., Beltram, F. et al. Vertically emitting microdisk lasers. Nature Photon 3, 46-49 (2009) (doi: https://doi.org/10.1038/nphoton.2008.248)
4. G. Liang, H. Liang, Y. Zhang, L. Li, A. Davies, E. Linfield, S. Yu, H. Liu, and Q. Wang, "Low divergence single-mode surface-emitting concentric-circular-grating terahertz quantum cascade lasers," Opt. Express 21, 31872-31882 (2013) (https://doi.org/10.1364/OE.21.031872)
5. Kapsalidis, F., Shahmohammadi, M., Süess, M.J. et al. Dual-wavelength DFB quantum cascade lasers: sources for multi-species trace gas spectroscopy. Appl. Phys. B 124, 107 (2018). (https://doi.org/10.1007/s00340-018-6973-2)
6. Wu, D. H., Razeghi, M. High power, low divergent, substrate emitting quantum cascade ring laser in continuous wave operation. APL Materials 5, 035505 (2017). (https://doi.org/10.1063/1.4978810)

## Claims

1. A cascade laser (10) comprising a plurality of semiconductor layers (14, 15, 16) extending in respective horizontal planes perpendicular to a vertical direction, the cascade laser (10) being configured to emit a laser beam at a lasing wavelength, A, the semiconductor layers (14, 15, 16) comprising in sequence:
a lower cladding layer (14);
a plurality of active region layers (15) to provide a gain medium for the cascade laser; and
an upper cladding layer (16),
wherein the semiconductor layers (14, 15, 16) collectively form an in-plane waveguide in a horizontal plane, and
wherein one of the upper and lower cladding layers (14, 16) is structured to define a higher order grating (28) of concentric rings that forces the in-plane waveguide to support a radial mode having substantial overlap with the gain medium and to couple out a component of the radial mode from the active region layers (15) as the laser beam, the higher order grating (28) being of order m in respect of the lasing wavelength, A, where m is at least 2.

2. The laser of claim 1, wherein the higher order grating (28) is of order m = 2.

3. The laser of claim 1 or 2, further comprising a first order grating (30) of concentric rings that are co-concentric with the concentric rings of the higher order grating, the first order grating (30) being of order m, where m = 1.

4. The laser of claim 1, 2 or 3, further comprising at least one radial gap (38) arranged between concentric subelements of the first and/or second order grating (28) and/or the first and higher order gratings (30, 28), the or each radial gap (38) having a radial extent equal to at least 2·λ / *n* to provide a gain section (38).

5. The laser of any preceding claim, further comprising:
first and second electrodes (22, 24) jointly arranged to apply a voltage bias across the active region layers (15) for current injection.

6. The laser of any of claims 1 to 5, configured to couple out the laser beam vertically downwards through the lower cladding layer (14).

7. The laser of any of claims 1 to 5, configured to couple out the laser beam vertically upwards through the upper cladding layer (16), the first electrode (22) being arranged over the upper cladding layer (16) and having an aperture (50) to allow passage of the laser beam out of the laser.

8. The laser of any preceding claim, further comprising a substrate (12) that is arranged to support the semiconductor layers (14, 15, 16).

9. The laser of claim 8, wherein the lower cladding layer (14) is an integral part of the substrate (12).

10. The laser of any preceding claim, wherein the higher order grating (28) is formed by a refractive index contrast in a horizontal plane between portions of the upper or lower cladding layer (14, 16) in which it is formed and an adjacent: metal layer (22); degenerately doped semiconductor layer; air; dielectric material; and further layer (40) of semiconductor material.

11. The laser of claim 10, wherein the further layer (40) is arranged at an interface of, or embedded within, the upper cladding layer (16).

12. The laser of any preceding claim, wherein the semiconductor layers (14, 15, 16) are collectively configured so that the in-plane waveguide has a lower loss and/or higher gain central region (31) and a higher loss and/or lower gain peripheral region (35) in order to suppress propagation of waveguiding modes in the peripheral region of the in-plane waveguide and promote propagation of waveguiding modes in the central region of the in-plane waveguide.

13. The laser of any preceding claim, wherein the higher order grating (28) is configured to force the in-plane waveguide to support only said radial mode, thereby to provide single mode laser output.

14. The laser of any of claims 1 to 13, wherein the plurality of active region layers (15) form a superlattice structure configured to provide gain through intraband transitions between quantum well subbands, thereby forming a quantum cascade laser.

15. The laser of any of claims 1 to 13, wherein the plurality of active region layers (15) form a superlattice structure configured to provide gain through interband transitions between quantum well subbands, thereby forming an interband cascade laser.
